(19) Europäisches Patentamt
European Patent Office
Office européen des brevets

(11) **EP 3 356 834 B1**

(12) **EUROPÄISCHE PATENTSCHRIFT**

(45) Veröffentlichungstag und Bekanntmachung des Hinweises auf die Patenterteilung:
**26.02.2020 Patentblatt 2020/09**

(21) Anmeldenummer: **16753339.7**

(22) Anmeldetag: **12.08.2016**

(51) Int Cl.:
**G01R 31/367** (2019.01)     **G01R 31/3842** (2019.01)
**G01R 31/389** (2019.01)

(86) Internationale Anmeldenummer:
**PCT/EP2016/069226**

(87) Internationale Veröffentlichungsnummer:
**WO 2017/084780 (26.05.2017 Gazette 2017/21)**

(54) **VERFAHREN ZUM RECHNERGESTÜTZTEN ERMITTELN VON PARAMETERN EINES ELEKTROCHEMISCHEN ENERGIESPEICHERS**

METHOD FOR DETERMINING PARAMETERS OF AN ELECTROCHEMICAL ENERGY STORE IN A COMPUTER-AIDED MANNER

PROCÉDÉ DE CALCUL ASSISTÉ PAR ORDINATEUR DE PARAMÈTRES D'UN ACCUMULATEUR D'ÉNERGIE ÉLECTROCHIMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.11.2015 DE 102015222683**

(43) Veröffentlichungstag der Anmeldung:
**08.08.2018 Patentblatt 2018/32**

(73) Patentinhaber: **Siemens Aktiengesellschaft 80333 München (DE)**

(72) Erfinder:
- **WOLFRUM, Philipp**
  **81539 München (DE)**
- **SEVERIN, Anja**
  **80636 München (DE)**

(56) Entgegenhaltungen:
**US-A1- 2013 006 455     US-A1- 2014 114 595**

- **ALA AL-HAJ HUSSEIN ET AL: "An overview of generic battery models", POWER AND ENERGY SOCIETY GENERAL MEETING, 2011 IEEE, IEEE, 24. Juli 2011 (2011-07-24), Seiten 1-6, XP032055694, DOI: 10.1109/PES.2011.6039674 ISBN: 978-1-4577-1000-1**
- **WANG YUJIE ET AL: "A method for state-of-charge estimation of Li-ion batteries based on multi-model switching strategy", APPLIED ENERGY, Bd. 137, 6. November 2014 (2014-11-06), Seiten 427-434, XP029098596, ISSN: 0306-2619, DOI: 10.1016/J.APENERGY.2014.10.034**
- **CHRISTOPHERSEN J P ET AL: "Lumped parameter modeling as a predictive tool for a battery status monitor", VEHICULAR TECHNOLOGY CONFERENCE, 2003. VTC 2003-FALL. 2003 IEEE 58TH ORLANDO, FL, USA 6-9 OCT. 2003; [IEEE VEHICULAR TECHNOLGY CONFERENCE], PISCATAWAY, NJ, USA,IEEE, US, Bd. 5, 6. Oktober 2003 (2003-10-06), Seiten 3257-3261, XP010702932, DOI: 10.1109/VETECF.2003.1286255 ISBN: 978-0-7803-7954-1**
- **JOHNSON V H: "Battery performance models in ADVISOR", JOURNAL OF POWER SOURCES, ELSEVIER SA, CH, Bd. 110, Nr. 2, 22. August 2002 (2002-08-22), Seiten 321-329, XP004393630, ISSN: 0378-7753, DOI: 10.1016/S0378-7753(02)00194-5**

**Beschreibung**

Die Erfindung betrifft ein Verfahren zum rechnergestützten Ermitteln von Parametern eines elektrochemischen Energiespeichers.

Um elektrochemische Energiespeicher ökonomisch betreiben zu können, ist es erforderlich, dass das Verhalten des Energiespeichers für einen bestimmten Zeithorizont in die Zukunft vorhergesagt wird. Hierzu werden bestimmte Parameter des elektrochemischen Energiespeichers benötigt, die oftmals schwer zu bestimmen sind.

In der Regel sind wichtige Parameter eines elektrochemischen Energiespeichers dem Hersteller des Energiespeichers bekannt. Jedoch handelt es sich hierbei oftmals um internes technisches Wissen des Herstellers, das dieser nicht veröffentlichen möchte. Darüber hinaus hat selbst die Bekanntmachung bestimmter Parameter durch den Hersteller den Nachteil, dass sich diese Parameter immer auf einen bestimmten Energiespeichertyp und nicht auf ein bestimmtes Energiespeicherexemplar beziehen. Es kann somit der Fall auftreten, dass sich ein bestimmter elektrochemischer Energiespeicher anders verhält, als dies in der Typspezifikation angegeben ist. Dies kann sich beispielsweise aus Schwankungen in den Herstellungsbedingungen ergeben.

Die Druckschrift Ala Al-Haj Hussein et al: "An overview of generic battery models", Power and Energy Society General Meeting, 2011 IEEE, IEEE, 24. Juli 2011 (2011-07-24), Seiten 1-6, offenbart mehrere generische Modelle eines elektrochemischen Energiespeichers, um dessen Klemmenspannung in Abhängigkeit vom Ladezustand des Energiespeichers und dem Lade- bzw. Entladestrom im Energiespeicher zu beschreiben.

Aufgabe der Erfindung ist es, auf einfache Weise aussagekräftige Parameter eines elektrochemischen Energiespeichers zu bestimmen.

Diese Aufgabe wird durch die unabhängigen Patentansprüche gelöst. Weiterbildungen der Erfindung sind in den abhängigen Ansprüchen definiert.

Das erfindungsgemäße Verfahren ermittelt Parameter eines elektrochemischen Energiespeichers, wobei der Begriff des elektrochemischen Energiespeichers weit zu verstehen ist und insbesondere beliebige Arten von Batterien umfassen kann. Vorzugsweise handelt es sich bei dem elektrochemischen Energiespeicher um einen Energiespeicher zur Zwischenspeicherung von Energie in elektrischen Energieerzeugungsanlagen oder Stromnetzen, beispielsweise zur Zwischenspeicherung von Energie, die durch regenerative Energieerzeugungsanlagen, wie Photovoltaikanlagen oder Windkraftanlagen, erzeugt wird.

In dem erfindungsgemäßen Verfahren wird eine Vielzahl von zeitlich aufeinander folgenden Messdatensätzen verarbeitet. Diese Messdatensätze können bereits vor der Durchführung des Verfahrens ermittelt worden sein, jedoch kann auch die Messung der Daten selbst Bestandteil des Verfahrens sein. Ein jeweiliger Messdatensatz der Vielzahl von Messdatensätzen umfasst für einen zugeordneten Messzeitpunkt folgende Messwerte:
einen Spannungsmesswert einer Klemmenspannung des Energiespeichers, einen Strommesswert eines Stromflusses in der Form eines Lade- oder Entladestroms des Energiespeichers und einen Ladezustandsmesswert des Ladezustands des Energiespeichers.

In speziellen Ausführungsformen ist ferner in einem jeweiligen Messdatensatz auch die Temperatur des elektrochemischen Energiespeichers zum zugeordneten Messzeitpunkt enthalten.

Im erfindungsgemäßen Verfahren wird ein vorgegebenes Modell des Energiespeichers verarbeitet, wobei dieses Modell die Klemmenspannung in Abhängigkeit von dem Ladezustand und dem Stromfluss des Energiespeichers beschreibt. Dieses vorgegebene Modell umfasst folgende unbestimmte Parameter (d.h. Parameter, welche zumindest zum Teil durch das erfindungsgemäße Verfahren zu ermitteln sind und somit zunächst Variablen im Modell darstellen):
eine Nominalruhespannung, welche die Ruhespannung des Energiespeichers ohne Stromfluss bei einem vorgegebenen Ladezustandswert (z.B. 50% der Vollladung) repräsentiert, einen Spannungsfaktor, der Teil eines von dem Ladezustand abhängigen Terms der Klemmenspannung ist, und einen Innenwiderstand des Energiespeichers, der Teil eines von dem Stromfluss anhängigen Terms der Klemmenspannung ist.

Im Rahmen des erfindungsgemäßen Verfahrens werden Gleichungsparameter zumindest eines linearen Gleichungssystems mittels mehrerer zweiter Messdatensätze und optional zusätzlich mittels mehrerer erster Messdatensätze und/oder dritter Messdatensätze festgelegt. Jeder der ersten bis dritten Messdatensätze (sofern vorhanden) ist aus der Vielzahl von Messdatensätzen ausgewählt. Jedem der ersten bis dritten Messdatensätze (sofern vorhanden) ist dabei ein eigenes lineares Gleichungssystem zugeordnet, dessen Gleichungsparameter bestimmt werden. Erfindungsgemäß sind bei den ersten Messdatensätzen die Temperaturen des Energiespeichers im Wesentlichen gleich groß. Demgegenüber sind die zweiten Messdatensätze Paare von Messdatensätzen zu aufeinander folgenden Messzeitpunkten mit einem Stromsprung in den Stromflüssen (d.h. den entsprechenden Strommesswerten) zu den aufeinander folgenden Messzeitpunkten. Die dritten Messdatensätze zeichnen sich dadurch aus, dass die Stromflüsse (d.h. die entsprechenden Strommesswerte) in diesen Messdatensätzen im Wesentlichen bei 0 liegen.

Nach Festlegen der entsprechenden Gleichungsparameter werden die bereits oben definierte Nominalruhespannung und der bereits oben definierte Spannungsfaktor durch Lösen des zumindest einen linearen Gleichungssystems ermittelt.

Im erfindungsgemäßen Verfahren basiert das vorgegebene Modell des elektrochemischen Energiespeichers auf folgender Gleichung:

$$U(t) = U0_{nom} + dU0 * (SOC(t) - p) + R\big(T, SOC(t)\big) * I(t),$$

wobei $t$ die Zeit ist;
wobei $U(t)$ die Klemmenspannung ist;
wobei $U0_{nom}$ die Nominalruhespannung ist,
wobei $dU0$ der Spannungsfaktor ist;
wobei $p$ der vorgegebene Ladezustandswert ist;
wobei $SOC(t)$ der Ladezustand ist;
wobei $R(T,SOC(t))$ der Innenwiderstand ist;
wobei $T$ die Temperatur ist;
wobei $I(t)$ der Stromfluss ist.

Das obige Modell ist an sich aus dem Stand der Technik bekannt und eignet sich sehr gut zur Beschreibung des Verhaltens eines elektrochemischen Energiespeichers.

Erfindungsgemäß werden die Gleichungsparameter des oder eines der linearen Gleichungssysteme mittels der zweiten Messdatensätze (d.h. bei Stromsprüngen) so festgelegt, dass das lineare Gleichungssystem mit den festgelegten Gleichungsparametern wie folgt lautet:

$$A * x = B$$

mit

$$A = \begin{pmatrix} 1 & SOC(i_1) - p \\ 1 & SOC(i_2) - p \end{pmatrix}, \qquad B = \begin{pmatrix} U(i_1) - R(i_1) * I(i_1) \\ U(i_2) - R(i_2) * I(i_2) \end{pmatrix}, \qquad x = \begin{pmatrix} U0_{nom} \\ dU0 \end{pmatrix},$$

wobei $i_1$ ein Messzeitpunkt aus einem ersten Paar von Messdatensätzen zu aufeinander folgenden Messzeitpunkten ist und $i_2$ ein Messzeitpunkt aus einem anderen zweiten Paar von Messdatensätzen zu aufeinander folgenden Messzeitpunkten ist;
wobei $R(i_1)$ der Innenwiderstand zum Messzeitpunkt $i_1$ ist und als Quotient aus der Differenz der Klemmenspannungen (d.h. der entsprechenden Spannungsmesswerte) zu den Messzeitpunkten des ersten Paars und der Differenz der Stromflüsse (d.h. der entsprechenden Strommesswerte) zu den Messzeitpunkten des ersten Paars ermittelt wird;
wobei $R(i_2)$ der Innenwiderstand zum Messzeitpunkt $i_2$ ist und als Quotient aus der Differenz der Klemmenspannungen (d.h. der entsprechenden Spannungsmesswerte) zu den Messzeitpunkten des zweiten Paars und der Differenz der Stromflüsse (d.h. der entsprechenden Strommesswerte) zu den Messzeitpunkten des zweiten Paars ermittelt wird.

Dieses Gleichungssystem kann mit an sich bekannten Methoden über die Bildung der Inversen der Matrix A gelöst werden.

Das erfindungsgemäße Verfahren weist den Vorteil auf, dass über einfach zu erfassende Messwerte eines elektrochemischen Energiespeichers aussagekräftige Parameter desselben in der Form einer Nominalruhespannung und eines Spannungsfaktors bestimmt werden können. Die ermittelten Parameter sind dabei spezifisch für den Energiespeicher, für den die entsprechenden Messdatensätze erfasst wurden. Mittels der Nominalruhespannung und des Spannungsfaktors können in an sich bekannter Weise Rückschlüsse auf den Betriebszustand des Energiespeichers bzw. dessen Lebensdauer gezogen werden.

In einer besonders bevorzugten Ausführungsform wird in dem vorgegebenen Modell des Energiespeichers der Innenwiderstand durch ein Produkt aus einer ersten Funktion und einer zweiten Funktion beschrieben, wobei die erste Funktion von der Temperatur des Energiespeichers und die zweite Funktion vom Ladezustand des Energiespeichers abhängt. Die erste Funktion ist dabei unbekannt, wohingegen die zweite Funktion vorgegeben ist. In einer bevorzugten Variante wird als zweite Funktion ein sog. Badewannenprofil verwendet, wie weiter unten noch näher beschrieben ist.

In einer weiteren Variante werden die Gleichungsparameter eines der linearen Gleichungssysteme mittels der ersten Messdatensätze (d.h. bei gleichen Temperaturen) festgelegt. Das lineare Gleichungssystem mit den festgelegten Gleichungsparametern lautet dabei wie folgt:

$$A * x = B$$

mit

$$A = \begin{pmatrix} 1 & SOC(i_1) - p & R_2(SOC(i_1)) * I(i_1) \\ 1 & SOC(i_2) - p & R_2(SOC(i_2)) * I(i_2) \\ 1 & SOC(i_3) - p & R_2(SOC(i_3)) * I(i_3) \end{pmatrix}, B = \begin{pmatrix} U(i_1) \\ U(i_2) \\ U(i_3) \end{pmatrix}, x = \begin{pmatrix} U0_{nom} \\ dU0 \\ R_1(T) \end{pmatrix},$$

wobei $i_1$, $i_2$ und $i_3$ jeweilige Messzeitpunkte für drei erste Messdatensätze sind;
wobei $T$ die Temperatur bei den ersten Messdatensätzen ist;
wobei $R_1$ die erste Funktion ist;
wobei $R_2$ die zweite Funktion ist.

Dieses Gleichungssystem kann mit an sich bekannten Methoden über die Bildung der Inversen der Matrix A gelöst werden.
In einer weiteren Variante des erfindungsgemäßen Verfahrens, in dem die Gleichungsparameter eines der linearen Gleichungssysteme wiederum mittels der ersten Messdatensätze festgelegt werden, werden diese ersten Messdatensätze in einem automatischen Modus des Verfahrens automatisiert bestimmt. Dabei werden die ersten Messdatensätze aus der Vielzahl von Messdatensätzen basierend auf einem Toleranzwert ausgewählt, wobei Temperaturen von zwei Messdatensätzen als gleich eingestuft werden, wenn sie weniger als der vorbestimmte Toleranzwert voneinander abweichen. Vorzugsweise ist die automatisierte Auswahl derart ausgestaltet, dass die Messzeitpunkte der ersten Messdatensätze die größtmöglichen Zeitabstände zueinander aufweisen. Hierdurch wird sichergestellt, dass eine numerisch stabile Lösung für das obige lineare Gleichungssystem erhalten wird.
In einer weiteren Variante des erfindungsgemäßen Verfahrens werden die zweiten Messdatensätze in einem automatischen Modus des Verfahrens automatisiert aus der Vielzahl von Messdatensätzen basierend auf einer Stromschwelle ausgewählt werden. Ein Stromsprung liegt dabei dann vor, wenn der Stromfluss (d.h. der entsprechende Strommesswert) von einem Messdatensatz zum zeitlich nächsten Messdatensatz die vorbestimmte Stromschwelle überschreitet. Die automatisierte Auswahl ist vorzugsweise derart ausgestaltet, dass Paare von Messdatensätzen mit dem größtmöglichen Unterschied in dem Ladezustandsmesswert der Paare zueinander ausgewählt werden. Hierdurch wird wiederum eine numerisch stabile Lösung für das obige Gleichungssystem sichergestellt.
In einer weiteren Variante des erfindungsgemäßen Verfahrens werden die Gleichungsparameter eines der linearen Gleichungssysteme mittels der dritten Messdatensätze festgelegt. Dabei lautet das lineare Gleichungssystem mit den festgelegten Gleichungsparametern wie folgt:

$$A * x = B$$

mit

$$A = \begin{pmatrix} 1 & SOC(i_1) - p \\ 1 & SOC(i_2) - p \\ \dots & \dots \\ 1 & SOC(i_n) - p \end{pmatrix}, B = \begin{pmatrix} U(i_1) \\ U(i_2) \\ \dots \\ U(i_n) \end{pmatrix}, \qquad x = \begin{pmatrix} U0_{nom} \\ dU0 \end{pmatrix},$$

wobei $i_1$, $i_2$, ..., $i_n$ jeweilige Messzeitpunkte der dritten Messdaten sind.
Dieses Gleichungssystem kann mit an sich bekannten Methoden über die Bildung der Pseudoinversen der Matrix A gelöst werden.
In einer bevorzugten Ausführungsform der Erfindung, in der die Gleichungsparameter eines der linearen Gleichungssysteme mittels der dritten Messdatensätze festgelegt werden, erhält man die dritten Messdatensätze in einem automatischen Modus des Verfahrens automatisiert aus der Vielzahl von Messdatensätzen basierend auf einer Stromschwelle, wobei ein Stromfluss von 0 dann vorliegt, wenn der Stromfluss (d.h. der entsprechende Strommesswert) kleiner als die vorbestimmte Stromschwelle ist. Vorzugsweise ist die automatisierte Auswahl derart ausgestaltet, dass dritte Messdatensätze mit größtmöglichen Unterschieden im Ladezustandswert ausgewählt werden, wodurch wiederum eine numerisch stabile Lösung des Gleichungssystems sichergestellt wird.

In einer weiteren Variante des erfindungsgemäßen Verfahrens werden neben der Nominalruhespannung und dem Spannungsfaktor ferner auch entsprechende Funktionsparameter der oben definierten ersten Funktion bestimmt, d.h. es wird die Abhängigkeit des Innenwiderstands von der Temperatur ermittelt. Die Funktionsparameter werden dabei unter Verwendung der Nominalruhespannung und des Spannungsfaktors bestimmt, welche im Rahmen des erfindungsgemäßen Verfahrens ermittelt werden. Vorzugsweise lautet dabei die erste Funktion wie folgt:

$$R_1(T) = (a_R * e^{-b_R * T} + c_R),$$

wobei $T$ die Temperatur des Energiespeichers ist;
wobei $a_R$, $b_R$ und $c_R$ die Funktionsparameter darstellen.

Bei der soeben beschriebenen Ermittlung der Funktionsparameter fließen in einer bevorzugten Variante des erfindungsgemäßen Verfahrens drei Messdatensätze zu unterschiedlichen Temperaturen ein. Vorzugsweise werden als die drei Messdatensätze aus der Vielzahl von Messdatensätzen die Messdatensätze mit dem größtmöglichen Abstand ihrer Temperaturen ausgewählt. Hierdurch wird eine numerisch stabile Bestimmung der Funktionsparameter gewährleistet.

Alternativ oder zusätzlich zu dem oben genannten automatischen Modus kann im Rahmen der Erfindung gegebenenfalls auch ein manueller Modus zur Auswahl der ersten und/oder zweiten und/oder dritten Messdatensätze genutzt werden. Gemäß diesem Modus wird eine Benutzerschnittstelle bereitgestellt und die entsprechenden Messdatensätze werden durch Spezifikation eines Benutzers an der Benutzerschnittstelle ausgewählt.

Neben dem oben beschriebenen Verfahren betrifft die Erfindung eine Vorrichtung zum rechnergestützten Ermitteln von Parametern eines elektrochemischen Energiespeichers, wobei die Vorrichtung eine Rechnereinheit umfasst, welche zur Durchführung des erfindungsgemäßen Verfahrens bzw. einer oder mehrerer bevorzugter Varianten des erfindungsgemäßen Verfahrens eingerichtet ist.

Darüber hinaus umfasst die Erfindung ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Die Erfindung betrifft darüber hinaus ein Computerprogramm mit einem Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Ausführungsbeispiele der Erfindung werden nachfolgend anhand der beigefügten Figuren detailliert beschrieben.

Es zeigen:

Fig. 1      eine schematische Darstellung eines elektrochemischen Energiespeichers, dessen Parameter unter anderem mit einer Ausführungsform des erfindungsgemäßen Verfahrens ermittelt werden;

Fig. 2      ein Ablaufdiagramm, welches die wesentlichen Schritte eines Verfahrens zum Ermitteln von Parametern eines elektrochemischen Energiespeichers verdeutlicht;

Fig. 3      ein Diagramm, welches ein Beispiel einer zweiten Funktion repräsentiert, welche vom Ladezustand des Energiespeichers abhängt und einen Term des Innenwiderstands des Energiespeichers darstellt;

Fig. 4 und Fig. 5      Diagramme, welche die Auswahl von Messdatensätzen mit Stromsprüngen gemäß einer Variante des erfindungsgemäßen Verfahrens verdeutlichen.

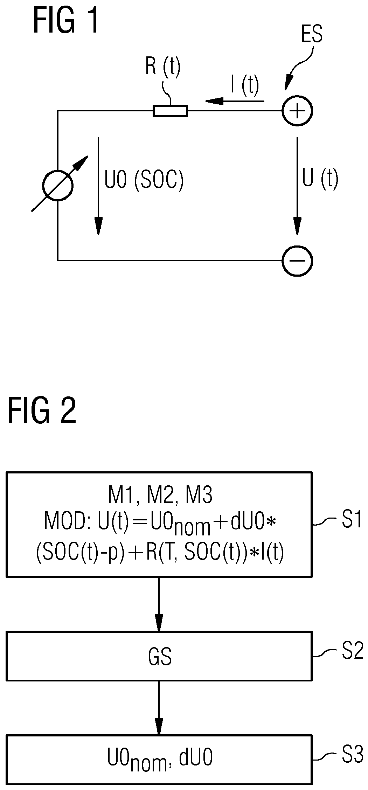

Nachfolgend werden Ausführungsformen anhand eines elektrochemischen Energiespeichers in der Form einer Batterie beschrieben. Ein solcher Energiespeicher ist in Fig. 1 gezeigt und mit ES bezeichnet. An den dargestellten Klemmen in der Form eines Pluspols und Minuspols der Batterie liegt die Klemmenspannung U(t) an, wobei die Variable t im Folgenden die Zeit bezeichnet. In der hier beschriebenen Ausführungsform wird die Batterie gerade geladen, so dass in die Batterie ein Ladestrom I(t) fließt. Die Batterie hat einen zeitlich variablen Innenwiderstand R(t), der vom aktuellen Ladezustand SOC und der Temperatur der Batterie abhängt. Ferner hat die Batterie eine Ruhespannung $U0(SOC)$, welche die Spannung der Batterie ohne Ladestrom ist und vom Ladezustand SOC abhängt. In den nachfolgend beschriebenen Ausführungsformen wird dabei eine Nominalruhespannung $U0_{nom}$ bei einem vorgegebenen Ladezustand SOC betrachtet, der beispielsweise bei 50% des voll geladenen Zustands liegt.

Wie oben erwähnt, wird in den nachfolgend beschriebenen Varianten ein Ladebetrieb der Batterie mit einem Ladestrom I(t) betrachtet. Der Ladestrom ist dabei als positiver Wert definiert. Nichtdestotrotz können die nachfolgenden Ausführungsformen analog auch für einen Betrieb der Batterie beim Entladen verwendet werden, wobei in diesem Fall der Strom I(t) einen Entladestrom mit negativem Vorzeichen repräsentiert.

Ziel der hier beschriebenen Varianten ist die Ermittlung von aussagekräftigen Parametern der Batterie basierend auf mehreren Messdatensätzen, welche zu verschiedenen Messzeitpunkten an der Batterie ermittelt bzw. gemessen wurden. Gegebenenfalls kann der Vorgang der Messung auch Teil des hier beschriebenen Verfahrens sein.

Es werden folgende Messwerte der Batterie zu jeweiligen Messzeitpunkten ermittelt:

- Ladestrom I(t) der Batterie;
- Klemmenspannung U(t) der Batterie;
- Temperatur T der Batterie;
- Ladezustand SOC der Batterie.

Mittels mehrerer solcher Messdatensätze werden dann die bereits oben erwähnte Nominalruhespannung $U0_{nom}$ sowie ein Spannungsfaktor dU0 ermittelt. Dieser Spannungsfaktor beschreibt einen linearen Zusammenhang der Veränderung der Klemmenspannung in Abhängigkeit von dem Ladezustand der Batterie, wie weiter unten beschrieben wird.

Alle nachfolgend erläuterten Varianten gehen von folgendem Modell zur Beschreibung der Klemmenspannung U(t) aus:

$$U(t) = U0_{nom} + dU0 * (SOC(t) - p) + R\big(T, SOC(t)\big) * I(t). \qquad (1)$$

Dabei bezeichnet $U0_{nom}$ die Nominalruhespannung bei einem vorgegebenen Ladezustandswert p, der in einer bevorzugten Variante bei 50% der Vollladung liegt. Die Variable dU0 stellt den bereits oben erwähnten Spannungsfaktor dar und R repräsentiert den Innenwiderstand der Batterie. Ferner bezeichnet I(t) den positiven Ladestrom und SOC(t) repräsentiert den Ladezustand.

Im Folgenden werden drei verschiedene Ausführungsformen beschrieben, wie die Parameter $U0_{nom}$ und dU0 ermittelt werden können. Die einzelnen Varianten können dabei in Abhängigkeit von den verfügbaren Messwerten individuell eingesetzt werden, oder gegebenenfalls auch in Kombination, um die Messgenauigkeit zu verbessern. Zur Erfindung gehört die weiter unten beschriebene zweite Variante bzw. jede Kombination von Varianten, welche die zweite Variante umfasst.

Fig. 2 zeigt ein Diagramm, welches die wesentlichen Verfahrensschritte der nachfolgend beschriebenen Ausführungsformen verdeutlicht. Ausgangspunkt des Verfahrens gemäß Schritt S1 ist eine Vielzahl von zeitlich aufeinander folgenden Messdaten, wobei je nach verwendeter Variante erste Messdaten M1 bei gleichen Temperaturwerten, zweite Messdaten M2 bei auftretenden Stromsprüngen bzw. dritte Messdaten M3 bei einem Ladestrom von im Wesentlichen 0 betrachtet werden. All diese Messdaten sind aus den ursprünglichen Messdaten ausgewählt. Jedes der nachfolgend beschriebenen Verfahren verwendet ein vorgegebenes Modell MOD der Klemmenspannung, das durch die oben genannte Gleichung (1) beschrieben ist, welche zur Veranschaulichung nochmals in Fig. 2 wiedergegeben ist. Basierend auf diesem Modell und unter Berücksichtigung der entsprechenden Messdatensätze werden dann in einem Schritt S2 Gleichungsparameter eines linearen Gleichungssystems GS festgelegt. Anschließend wird dieses Gleichungssystem GS in Schritt S3 mit bekannten Methoden gelöst, wodurch die entsprechenden Parameter $U0_{nom}$ und dU0 der Batterie erhalten werden.

Gemäß einer ersten Variante, die auch als Temperaturmethode bezeichnet wird, werden die Parameter $U0_{nom}$ und dU0 basierend auf ersten Messdatensätzen M1 erhalten. Alle Messwerte dieser ersten Messdatensätze wurden im Wesentlichen bei gleicher Temperatur der Batterie bestimmt. Für die Temperaturmethode wird die obige Gleichung (1) zur Beschreibung der Klemmenspannung U(t) wie folgt geschrieben:

$$U(t) = U0_{nom} + dU0 * (SOC(t) - p) + R_1(T) * R_2(SOC) * I(t). \qquad (2)$$

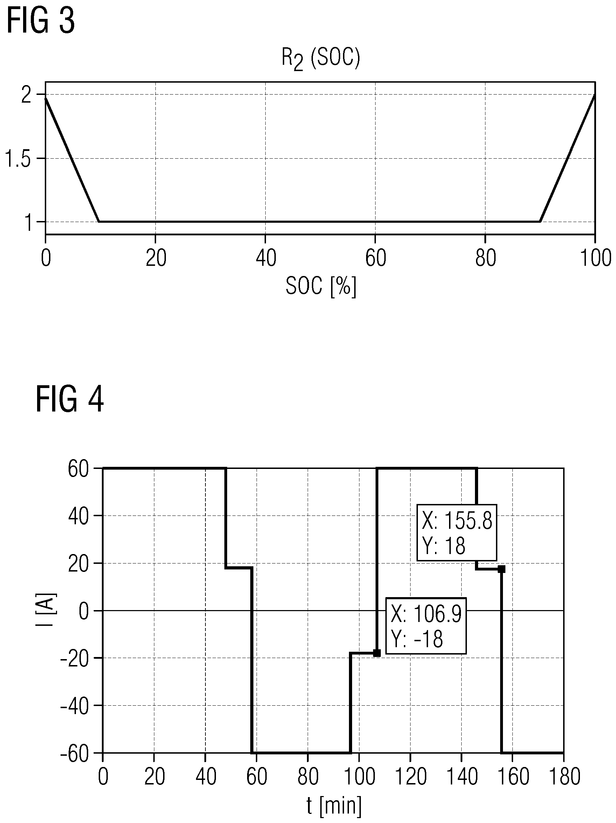

Dabei wird in an sich bekannter Weise der interne Widerstand R(T,SOC(t)) als ein Produkt aus einer rein temperaturabhängigen ersten Funktion $R_1(T)$ und einer rein vom Ladezustand abhängigen zweiten Funktion $R_2(SOC)$ beschrieben. Die zweite Funktion ist vorgegeben und wurde vorab empirisch bestimmt. Ein Beispiel eines Verlaufs der zweiten Funktion ist in Fig. 3 dargestellt. Die Funktion verläuft dabei nach Art eines sog. Badewannenprofils. Gemäß diesem Profil fällt die Funktion bei kleinen SOC-Werte bis etwa 10% zunächst linear ab und verläuft dann bis zu einem SOC-Wert von in etwa 90% konstant. Anschließend steigt die Funktion wieder linear an. In der obigen Gleichung (2) sind U(i), SOC(i) und I(i) für jeden Zeitpunkt i der Messdatensätze bekannt. Da auch die zweite Funktion $R_2(i)$ als bekannt angenommen wird, verbleiben die drei unbekannten Variablen $U0_{nom}$, $dU0$ sowie $R_1(T)$.

Wie bereits erwähnt, werden nunmehr erste Messdatensätze mit im Wesentlichen der gleichen Temperatur T des Energiespeichers betrachtet. Es werden dabei drei solcher Messdatensätze zu entsprechenden Zeitpunkten $(i_1, i_2, i_3)$ mit der entsprechenden Temperatur T bestimmt. Dies kann automatisiert erfolgen, wie im Folgenden noch näher erläutert wird. Gegebenenfalls kann auch eine Benutzerschnittstelle vorgesehen sein, über welche ein Benutzer entsprechende Messdatensätze mit den gleichen Temperaturen festlegt. Unter Berücksichtigung dieser drei Messdatensätze lässt sich dann ein lineares Gleichungssystem $A * x = B$ vom Rang 3 konstruieren, wobei gilt:

$$A = \begin{pmatrix} 1 & SOC(i_1) - p & R_2(SOC(i_1)) * I(i_1) \\ 1 & SOC(i_2) - p & R_2(SOC(i_2)) * I(i_2) \\ 1 & SOC(i_3) - p & R_2(SOC(i_3)) * I(i_3) \end{pmatrix}, B = \begin{pmatrix} U(i_1) \\ U(i_2) \\ U(i_3) \end{pmatrix}, x = \begin{pmatrix} U0_{nom} \\ dU0 \\ R_1(T) \end{pmatrix}. \qquad (3)$$

Dieses Gleichungssystem wird anschließend in an sich bekannter Weise über die Bestimmung der Inversen von A gelöst, d.h. es wird bestimmt:

$$x = A^{-1} * B.$$

Man erhält somit die Batterieparameter $U0_{nom}$ und $dU0$.

Im Folgenden wird beschrieben, wie aus den Messdatensätzen automatisiert solche (ersten) drei Messdatensätze mit gleicher Temperatur bestimmt werden können.

In einem Schritt 1 wird ein Toleranzwert einer Temperaturdifferenz $T_{eps}$ festgelegt.

In einem Schritt 2 wird eine Zieltemperatur $T_t$ der entsprechenden ersten Messdatensätze auf die Minimaltemperatur $T_{min}$ aller Temperaturen der vorhandenen Messdatensätze gesetzt.

In einem Schritt 3 werden $n \geq 3$ Messzeitpunkte mit folgender Temperaturbedingung ermittelt: $T(i_1, i_2,...,i_n) \in [T_t - T_{eps}, T_t + T_{eps}]$. Falls drei solcher Messzeitpunkte nicht gefunden werden können, wird die Zieltemperatur $T_t$ um d_Temp erhöht ($T_t = T_t + $ d_Temp) und Schritt 3 wiederholt, und zwar maximal bis $T_t = T_{max}$ erreicht ist. Falls $n \geq 3$ Zeitpunkte gefunden werden, wird zu Schritt 4 übergegangen.

In Schritt 4 wird überprüft, ob einige der n Messzeitpunkte benachbart zueinander liegen. Ist dies der Fall, wird ein einzelner Messzeitpunkt des jeweiligen Satzes von benachbarten Messzeitpunkten beibehalten und die restlichen Messzeitpunkte des Satzes gestrichen. Dies ist erforderlich, da benachbarte Messzeitpunkte dazu führen können, dass die obere Matrix A numerisch instabil wird, da sie nicht mehr den Rang 3 aufweist. In einem solchen Fall kann die Variable x nicht mehr bestimmt werden. Nach Streichung der Messzeitpunkte wird zum nächsten Schritt 5 übergegangen.

In Schritt 5 wird zunächst überprüft, ob es weiterhin mindestens drei Messzeitpunkte nach Streichung von benachbarten Messzeitpunkten gibt. Ist dies der Fall, wurde ein geeigneter Satz von Messzeitpunkten $(i_1, i_2,...,i_n)$ gefunden und es wird zu Schritt 6 übergegangen. Ist dies nicht der Fall, wird die Zieltemperatur $T_t$ mit dem Inkrement d Temp ($T_t = T_t + $ d_Temp) erhöht und zu Schritt 3 zurückgegangen.

In Schritt 6 werden aus dem Satz $(i_1, i_2,...,i_n)$ der Messzeitpunkte mit gleicher Temperatur diejenigen Indizes ausgewählt, welche die größte Zeitdifferenz aufspannen, d.h. es werden hieraus $i_1, i_n$ als Indizes sowie der zusätzliche Index ausgewählt, der benachbart zu $(i_1 + i_n)/2$ liegt.

In Schritt 7 wird überprüft, ob $T_t < T_{max}$ gilt. Ist dies der Fall, wird zu Schritt 3 zurückgegangen, um zusätzliche geeignete Sätze von Messzeitpunkten zu finden. Ansonsten wird das Verfahren beendet, sofern zumindest ein Satz von Messzeitpunkten gefunden wurde. Konnte ein solcher Satz nicht gefunden werden, wird der Toleranzwert $T_{eps}$ erhöht und zu Schritt 2 zurückgegangen.

Nach der soeben durchgeführten Iteration ist es möglich, dass es mehr Sätze von geeigneten Messzeitpunkten und damit ersten Messdatensätzen gibt. In diesem Fall wird derjenige Satz identifiziert, der zu der Matrix A führt, welche numerisch am stabilsten ist. Hierzu wird für jeden Satz von drei Messzeitpunkten gleicher Temperatur die Varianz der zweiten und dritten Spalte der Matrix A berechnet. Es wird dann derjenige Satz von Messzeitpunkten mit der maximalen Summe der Varianzen aus der zweiten und dritten Spalte bestimmt. Für diesen optimalen Satz entsprechender Messzeitpunkte werden dann die Matrizen A und B ermittelt und der Vektor x und somit die Parameter $U0_{nom}$ und dU0 bestimmt.

In einer zweiten Variante des hier beschriebenen Verfahrens, die als Stromsprungmethode bezeichnet wird, erfolgt die Bestimmung von $U0_{nom}$ sowie dU0 bei auftretenden Stromsprüngen zwischen zeitlich benachbarten Messdatensätzen.

Es wird wiederum folgendes Modell für die Klemmenspannung betrachtet:

$$U(t) = U0_{nom} + dU0 * (SOC(t) - p) + R(t) * I(t). \qquad (4)$$

Dabei wird der Innenwiderstand R(t) wiederum durch eine erste und zweite Funktion wie folgt beschrieben:

$$R(t) = R_2\big(SOC(t)\big) * R_1\big(T(t)\big) \qquad (5)$$

In der obigen Gleichung (4) sind für jeden Messzeitpunkt i die Größen U(i), SOC(i) und I(i) bekannt. Es gibt somit nur die drei unbekannten Variable $U0_{nom}$, dU0 und R(i).

Es wird nunmehr die Tatsache genutzt, dass zu Messzeitpunkten, an denen ein plötzlicher Stromsprung (d.h. eine große Stromänderung) des Stromflusses I(t) auftritt, sich die Temperatur T sowie der Ladezustand SOC nicht signifikant ändern. Demzufolge kann der Innenwiderstand R(t) vor und nach dem Stromsprung als konstant angenommen werden und basierend auf folgender Gleichung ermittelt werden:

$$R(i) = \frac{U(i + 1) - U(i)}{I(i + 1) - I(i)}.$$

Dabei bezeichnet i den Messzeitpunkt vor dem Stromsprung und i+1 den Messzeitpunkt nach dem Stromsprung. Demzufolge ist auch der Innenwiderstand R(i) am entsprechenden Stromsprung bekannt und es verbleiben nur $U0_{nom}$ sowie dU0 als unbekannte Variablen.

In der hier beschriebenen Stromsprungmethode werden nunmehr zwei Stromsprünge in den Messdatensätzen identifiziert und basierend darauf das lineare Gleichungssystem $A * x = B$ definiert, wobei gilt:

$$A = \begin{pmatrix} 1 & SOC(i_1) - p \\ 1 & SOC(i_2) - p \end{pmatrix}, \qquad B = \begin{pmatrix} U(i_1) - R(i_1) * I(i_1) \\ U(i_2) - R(i_2) * I(i_2) \end{pmatrix}, \qquad x = \begin{pmatrix} U0_{nom} \\ dU0 \end{pmatrix}. \qquad (6)$$

Dabei bezeichnet $i_1$ einen Messzeitpunkt von benachbarten Messzeitpunkten eines Stromsprungs und $i_2$ einen Messzeitpunkt von benachbarten Messzeitpunkten des anderen Stromsprungs.

Das obige Gleichungssystem (6) wird dann durch Bestimmung der Inversen von A ermittelt, d.h. es wird bestimmt:

$$x = A^{-1} * B.$$

Auf diese Weise erhält man wiederum die Batterieparameter dU0 und $U0_{nom}$.

Im Folgenden wird beschrieben, wie entsprechende Stromsprünge automatisiert aus den Messdatensätzen ausgewählt werden können.

In einem Schritt 1 wird ein Zähler c=0 initialisiert.

In einem Schritt 2 wird die maximale Verteilung der Ladeströme in Abhängigkeit von den vorhandenen Messdatensätzen bestimmt, d.h. es wird $\Delta max = |I_{max} - I_{min}|$ ermittelt.

In einem Schritt 3 wird ein initialer Schwellenfaktor f (z.B. f=0.3) bestimmt. Ein Stromsprung wird für zwei aufeinander folgende Messzeitpunkte i und i+1 dabei dann identifiziert, wenn folgende Bedingung gilt:

$$| I(i + 1) - I(i) | > f * \Delta max. \qquad (7)$$

In einem Schritt 4 wird beginnend mit dem Messzeitpunkt i=1 überprüft, ob die obige Bedingung gemäß Gleichung (7) erfüllt ist. Ist dies der Fall, wurde ein geeigneter Stromsprung ermittelt. Anschließend wird der Zähler c erhöht und der entsprechende Zeitpunkt i gespeichert. Schließlich wird mit i=i+1 fortgefahren und der Schritt 4 solange wiederholt, bis alle Messdatensätze durchlaufen wurden.

In einem Schritt 5 wird überprüft, ob wenigstens zwei Stromsprünge ermittelt wurden. Ist dies der Fall, wird zu Schritt 6 übergegangen. Ist dies nicht der Fall, wird der Schwellenfaktor f (z.B. f=0.9*f) vermindert und zu Schritt 4 zurückgegangen, bis c≥2 Stromsprünge gefunden wurden oder bis der Schwellenfaktor f unter einem Minimalwert (z.B. $f_{min} = 0.05$) gefallen ist. Im Falle von $f < f_{min}$ wurden nicht genug Stromsprünge gefunden und der Algorithmus wird beendet.

In Schritt 6 werden aus den jeweiligen Stromsprüngen (d.h. den Paaren von aufeinander folgenden Messzeitpunkten der jeweiligen Stromsprünge) diejenigen Stromsprünge ausgewählt, für welche die Differenz zwischen dem Ladezustandswert der Batterie am größten ist. Dies erfolgt dadurch, dass diejenigen beiden Stromsprünge aus den ermittelten Stromsprüngen ausgewählt werden, für welche der Ladezustand maximal und minimal ist. Hierdurch wird berücksichtigt, dass zwei Messzeitpunkte mit im Wesentlichen dem gleichen Ladezustand dazu führen würden, dass die Matrix A numerisch instabil wird. In diesem Fall kann A nicht zur Berechnung des obigen Vektors x und damit von $U0_{nom}$ und dU0 verwendet werden.

In einem Schritt 7 wird dann mittels des obigen Gleichungssystems (6) $U0_{nom}$ und dU0 bestimmt.

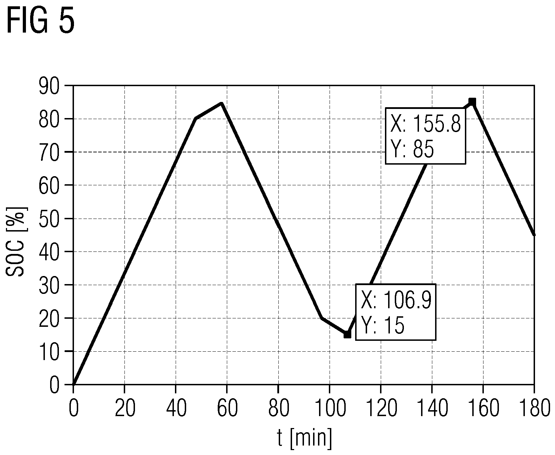

Fig. 4 und Fig. 5 zeigen zwei Diagramme, welche ein Ergebnis des soeben beschriebenen Algorithmus zur automatisierten Auswahl von Stromsprüngen wiedergeben. Fig. 4 repräsentiert dabei die Stromwerte I über die Zeit t (d.h. die aufeinander folgenden Messzeitpunkte), wohingegen Fig. 5 die entsprechenden SOC-Werte zu den Messzeitpunkten aus Fig. 4 wiedergibt. Über zwei Rechtecke in den jeweiligen Diagrammen werden dabei Stromsprünge angezeigt, die mit dem Algorithmus identifiziert wurden. Wie man aus dem Vergleich von Fig. 4 und Fig. 5 erkennt, wurden als die beiden Stromsprünge diejenigen ausgewählt, für welche die SOC-Differenz maximal ist.

Alternativ zu der soeben beschriebenen mathematischen Bestimmung von Stromsprüngen kann gegebenenfalls auch wieder eine Benutzerschnittstelle vorgesehen sein, über welche ein Benutzer interaktiv Stromsprünge in den Messdatensätzen festlegen kann. Zum Beispiel kann hierzu der aktuelle zeitliche Verlauf des Stroms wiedergegeben werden, so dass der Benutzer, beispielsweise über eine Maus, diejenigen Punkte wählen kann, welche als Stromsprünge zu behandeln sind.

Nachfolgend wird eine dritte Variante der Erfindung zur Bestimmung von $U0_{nom}$ und dU0 beschrieben. In dieser Variante werden solche Messdatensätze betrachtet, bei denen der Strom I(t) im Wesentlichen bei 0 liegt. Demzufolge kann die obige Gleichung (1) für die Klemmenspannung U(t) wie folgt vereinfacht werden:

$$U(t) = U0_{nom} + dU0 * (SOC(t) - p). \qquad (8)$$

Bei dieser Variante werden $n \geq 2$ Messzeitpunkte mit einem Strom von im Wesentlichen 0 ermittelt (sofern vorhanden) und anschließend das folgende Gleichungssystem aus n linearen Gleichungen definiert:

$$A * x = B,$$

wobei:

$$A = \begin{pmatrix} 1 & SOC(i_1) - p \\ 1 & SOC(i_2) - p \\ \cdots & \cdots \\ 1 & SOC(i_n) - p \end{pmatrix}, \qquad B = \begin{pmatrix} U(i_1) \\ U(i_2) \\ \cdots \\ U(i_n) \end{pmatrix}, \qquad x = \begin{pmatrix} U0_{nom} \\ dU0 \end{pmatrix}. \qquad (9)$$

Dieses Gleichungssystem wird gelöst, wobei hierzu die Pseudoinverse von A bestimmt wird, d.h. es wird der Vektor x wie folgt ermittelt:

$$x = A^+ * B.$$

In dieser Variante werden mindestens zwei Messzeitpunkte benötigt, es kann jedoch auch eine größere Anzahl verwendet werden. Je größer die Anzahl von Messzeitpunkten ist, desto robuster ist der Algorithmus.

Im Folgenden wird beschrieben, wie die Messzeitpunkte mit entsprechenden Stromwerten von 0 automatisiert bestimmt werden können. Alternativ können diese Messzeitpunkte jedoch auch manuell über eine Benutzerschnittstelle spezifiziert werden.

In einem Schritt 1 werden solche Messzeitpunkte i aus den Messdatensätzen bestimmt, für welche $|I(i)| < I_{threshold}$ gilt. Je nach Ausgestaltung kann die Größe $I_{threshold}$ geeignet festgelegt werden (z.B. 1e-4). Die aufgefundenen Messzeitpunkte werden dann als Messzeitpunkte mit Stromwerten von 0 behandelt. Sollten nicht wenigstens zwei Messzeitpunkte in Schritt 1 gefunden werden, kann das Verfahren zur Bestimmung der Batterieparameter nicht durchgeführt werden und der Algorithmus wird beendet.

Sollten mehrere solcher Messzeitpunkte ermittelt werden, wird in einem Schritt 2 aus diesen Messzeitpunkten derjenige mit dem kleinsten und dem größten SOC-Wert ausgewählt. Dies führt wiederum zu der besten numerischen Stabilität.

In einem Schritt 3 werden anschließend diejenigen Messzeitpunkte aus dem Satz der Messzeitpunkte mit Stromwerten von 0 entfernt, welche SOC-Werte in der Nähe der bereits gewählten Messzeitpunkte aufweisen. Auf diese Weise werden zur Ermittlung der Batterieparameter solche Messzeitpunkte gesucht, deren SOC-Werte einen großen Abstand zu den bereits gewählten Messzeitpunkten aufweisen.

In einer weiteren Ausgestaltung, welche mit jeder der oben beschriebenen Varianten zur Bestimmung von dU0 und U0$_{nom}$ kombiniert werden kann, werden ferner Parameter zur Beschreibung der obigen ersten Funktion R$_1$(t) ermittelt. Es wird dabei davon ausgegangen, dass diese erste Funktion über die Parameter a$_R$, b$_R$ und c$_R$ beschrieben werden kann, wobei R$_1$(t) wie folgt lautet:

$$R_1(T) = a_R * e^{-b_R*T} + c_R. \qquad (10)$$

Der Innenwiderstand R wird somit durch folgende Gleichung repräsentiert:

$$R(T, SOC) = R_1(T) * R_2(SOC) = (a_R * e^{-b_R*T} + c_R) * R_2(SOC). \qquad (11)$$

Die zweite Funktion R$_2$(SOC) ist wiederum bekannt und kann z.B. durch das obige Badewannenprofil repräsentiert werden.

Zur Ermittlung der Parameter a$_R$, b$_R$ und c$_R$ werden drei Messzeitpunkte $(i_1, i_2, i_3)$ mit unterschiedlichen Temperaturwerten $T(i_1), T(i_2), T(i_3)$ ausgewählt. Die Messzeitpunkte $(i_1, i_2, i_3)$ können beispielsweise zufällig aus den Messdatensätzen ausgewählt werden. Vorzugsweise werden die Messzeitpunkte jedoch derart gewählt, dass die Temperaturen $T(i_1), T(i_2), T(i_3)$ den größtmöglichen Abstand voneinander aufweisen. Um dies zu erreichen, werden als Messzeitpunkte $i_1$ und $i_3$ die Messzeitpunkte mit dem Minimum und dem Maximum aller Temperaturen aus Messdatensätzen bestimmt. Als weiterer Messzeitpunkt $i_2$ wird dann ungefähr der mittlere Temperaturwert zwischen der minimalen und maximalen Temperatur festgelegt, d.h. es gilt

$$T(i_1), = T_{min}, \qquad T(i_3) = T_{max}, \qquad T(i_2) \approx \frac{T_{min} + T_{max}}{2}.$$

Unter Verwendung der obigen Gleichungen (4) und (5) kann für entsprechende Messzeitpunkte i die erste Funktion wie folgt geschrieben werden:

$$R_1(T(i)) = \frac{U(T(i)) - U0_{nom} - dU0 * (SOC(T(i)) - p)}{R_2(SOC(T(i))) * I(T(i))}. \qquad (12)$$

In dieser Gleichung sind U(i), SOC(i) und I(i) bekannt. Ferner sind die konstanten Parameter U0$_{nom}$ und dU0 bekannt, da sie mit einer der zuvor beschriebenen Methoden ermittelt wurden. Ebenso ist R$_2$ bekannt, das z.B. durch das oben beschriebene Badewannenprofil repräsentiert wird.

Es werden nunmehr die Größen $R_1(T(i_1))$, $R_1(T(i_2))$ und $R_1(T(i_3))$ für die drei ausgewählten Messzeitpunkte gemäß obiger Gleichung (12) bestimmt. Anschließend wird der folgende Algorithmus zum Auffinden der Parameter a$_R$, b$_R$ und c$_R$ genutzt (hierbei werden die folgenden Abkürzungen verwendet: $T(i_1) = T_1$, $T(i_2) = T_2$, $T(i_3) = T_3$).

Es wird die Hilfsvariable $R_x = \frac{R_1(T_1) - R_1(T_2)}{R_1(T_1) - R_1(T_3)}$ berechnet.

Anschließend wird mit einer Methode zum Finden von Nullstellen (z.B. Newton-Suche) die folgende Gleichung gelöst:

$$R_x - \frac{1 - e^{b_R*(T_1-T_2)}}{1 - e^{b_R*(T_1-T_3)}} = 0. \qquad (13)$$

Auf diese Weise erhält man den Parameter $b_R$.

Hieraus können dann die Parameter $a_R$ und $c_R$ wie folgt ermittelt werden:

$$a_R = \frac{R_1(T_1) - R_1(T_2)}{e^{-b_R*T_1} - e^{-b_R*T_2}}, \quad c_R = R_1(T_1) - a_R * e^{-b_R*T_1}. \qquad (14)$$

Wie man erkennt, modelliert der obige Zusammenhang $R_1(T) = (a_R * e^{-b_R*T} + c_R)$ die Temperaturabhängigkeit nicht-linear. Nichtsdestotrotz wird dabei auch ein linearer Zusammenhang beschrieben, sofern der Parameter $b_R$ sehr klein ist. Im Falle, dass die tatsächliche Temperaturabhängigkeit nahezu linear ist, wird dies mit dem hier beschriebenen Verfahren aufgrund eines sehr kleinen Werts von $b_R$ detektiert.

Die im Vorangegangenen beschriebenen Ausführungsformen weisen eine Reihe von Vorteilen auf. Insbesondere werden wichtige Parameter eines elektrochemischen Energiespeichers in der Form einer Nominalruhespannung und eines Spannungsfaktors ohne die Verwendung eines speziellen Messprotokolls bestimmt. Vielmehr muss lediglich eine ausreichende Anzahl an Messdatensätzen vorliegen, welche während des Betriebs der Batterie erfasst wurden. Darüber hinaus ermöglicht das Verfahren gegebenenfalls auch die Bestimmung der Temperaturabhängigkeit des Innenwiderstands der Batterie.

Es können drei unterschiedliche Ansätze genutzt werden, um die Batterieparameter zu bestimmen. Gegebenenfalls können die Ergebnisse dieser unterschiedlichen Ansätze zur gegenseitigen Validierung und Verbesserung der Schätzergebnisse, z.B. bei verrauschten Daten, miteinander kombiniert werden.

Das Verfahren benötigt keine besondere Initialisierung mit bestimmten Parameterwerten. Darüber hinaus kann das Verfahren vollautomatisch ablaufen, wobei in diesem Fall auch automatisch entsprechende Messdatensätze ausgewählt werden. Nichtsdestotrotz kann alternativ oder zusätzlich auch eine interaktive Auswahl von Messdatensätzen durch einen Benutzer über eine Benutzerschnittstelle durchgeführt werden.

Mit dem Verfahren werden Batterieparameter nicht für einen bestimmten Batterietyp bestimmt, sondern individuell für die einzelne Batterie, die gerade genutzt wird. Im Besonderen können mit den Parametern über an sich bekannte Methoden die Gesamtlebensdauer, die erwarteten Energieverluste, der erwartete Zeitpunkt bis zum Austausch und dergleichen vorhergesagt werden. Auf diese Weise liefert das Verfahren wichtige Ergebnisse für eine modellbasierte Planung und Optimierung einer Batterie während ihrer Betriebsdauer.

**Patentansprüche**

1. Verfahren zum rechnergestützten Ermitteln von Parametern eines elektrochemischen Energiespeichers (ES), wobei eine Vielzahl von zeitlich aufeinander folgenden Messdatensätzen (M1, M2, M3) verarbeitet wird, wobei ein jeweiliger Messdatensatz (M1, M2, M3) für einen zugeordneten Messzeitpunkt folgende Messwerte umfasst:

   einen Spannungsmesswert einer Klemmenspannung (U(t)) des Energiespeichers (ES), einen Strommesswert eines Stromflusses (I(t)) in der Form eines Lade- oder Entladestroms des Energiespeichers (ES) und einen Ladezustandsmesswerts des Ladezustands (SOC(t)) des Energiespeichers (ES);
   wobei ein vorgegebenes Modell (MOD) des Energiespeichers (ES) verarbeitet wird, das die Klemmenspannung (U(t)) in Abhängigkeit von dem Ladezustand (SOC(t)) und dem Stromfluss (I(t)) beschreibt, wobei das vorgegebene Modell (MOD) folgende unbestimmte Parameter umfasst:

   eine Nominalruhespannung (U0$_{nom}$), welche die Ruhespannung des Energiespeichers (ES) ohne Stromfluss (I(t) bei einem vorgegebenen Ladezustandswerts (p) repräsentiert, einen Spannungsfaktor (dU0), der Teil eines von dem Ladezustand (SOC(t)) abhängigen Terms der Klemmenspannung (U(t)) ist, und einen Innenwiderstand (R(T,SOC)) des Energiespeichers (ES), der Teil eines von dem Stromfluss (I(t)) abhängigen Terms der Klemmenspannung (U(t)) ist;
wobei in dem Verfahren folgende Schritte durchgeführt werden:

- Festlegen von Gleichungsparametern zumindest eines linearen Gleichungssystems (GS), das auf dem vorgegebenen Modell (MOD) basiert;
- Ermitteln der Nominalruhespannung (U0$_{nom}$) und des Spannungsfaktors (dU0) durch Lösen des zumindest einen linearen Gleichungssystems,

**dadurch gekennzeichnet, dass**

- die Gleichspannungsparameter des oder eines der linearen Gleichungssysteme mittels mehrerer zweiter Messdatensätze (M2), welche Paare von Messdatensätzen zu aufeinander folgenden Messzeitpunkten mit einem Stromsprung in den Stromflüssen (I(t)) zu den aufeinander folgenden Messzeitpunkten sind, festgelegt werden;
- wobei das vorgegebene Modell (MOD) des Energiespeichers (ES) auf folgender Gleichung basiert:

$$U(t) = U0_{nom} + dU0 * (SOC(t) - p) + R\big(T, SOC(t)\big) * I(t),$$

wobei $t$ die Zeit ist;
wobei $U(t)$ die Klemmenspannung ist;
wobei $U0_{nom}$ die Nominalruhespannung ist;
wobei $dU0$ der Spannungsfaktor ist;
wobei $p$ der vorgegebene Ladezustandswert ist;
wobei $SOC(t)$ der Ladezustand ist;
wobei $R(T,SOC(t))$ der Innenwiderstand ist;
wobei $T$ die Temperatur ist;
wobei $I(t)$ der Stromfluss ist;

- wobei das oder das eine der linearen Gleichungssysteme mit den festgelegten Gleichungsparametern wie folgt lautet:

$$A * x = B$$

mit

$$A = \begin{pmatrix} 1 & SOC(i_1) - p \\ 1 & SOC(i_2) - p \end{pmatrix}, \qquad B = \begin{pmatrix} U(i_1) - R(i_1) * I(i_1) \\ U(i_2) - R(i_2) * I(i_2) \end{pmatrix}, \qquad x = \begin{pmatrix} U0_{nom} \\ dU0 \end{pmatrix}$$

wobei $i_1$ ein Messzeitpunkt aus einem ersten Paar von Messdatensätzen zu aufeinander folgenden Messzeitpunkten ist und $i_2$ ein Messzeitpunkt aus einem anderen zweiten Paar von Messdatensätzen zu aufeinander folgenden Messzeitpunkten ist;
wobei $R(i_1)$ der Innenwiderstand (R(T,SOC)) zum Messzeitpunkt $i_1$ ist und als Quotient aus der Differenz der Klemmenspannungen (U(t)) zu den Messzeitpunkten des ersten Paars und der Differenz der Stromflüsse zu den Messzeitpunkten des ersten Paars ermittelt wird;
wobei $R(i_2)$ der Innenwiderstand (R(T,SOC)) zum Messzeitpunkt $i_2$ ist und als Quotient aus der Differenz der Klemmenspannungen (U(t)) zu den Messzeitpunkten des zweiten Paars und der Differenz der Stromflüsse (I(t)) zu den Messzeitpunkten des zweiten Paars ermittelt wird.

2. Verfahren nach Anspruch 1, wobei das Festlegen von Gleichungsparametern des zumindest einen linearen Gleichungssystems (GS) zusätzlich mittels mehrerer erster Messdatensätze (M1), bei denen die Temperaturen (T) des Energiespeichers (ES) im Wesentlichen gleich groß sind, und/oder mittels mehrerer dritter Messdatensätze, bei denen die Stromflüsse (I(t)) im Wesentlichen bei null liegen, erfolgt.

3. Verfahren nach Anspruch 1 oder 2, wobei in dem vorgegebenen Modell (MOD) der Innenwiderstand (R(T,SOC)) durch ein Produkt aus einer ersten Funktion und einer zweiten Funktion beschrieben wird, wobei die erste Funktion von der Temperatur (T) des Energiespeichers (ES) und die zweite Funktion vom Ladezustand (SOC(t)) des Energiespeichers (ES) abhängt und wobei die erste Funktion unbekannt ist und die zweite Funktion vorgegeben ist.

4. Verfahren nach Anspruch 2 und 3, wobei die Gleichungsparameter eines der linearen Gleichungssysteme (GS) mittels der ersten Messdatensätze (M1) festgelegt werden und das lineare Gleichungssystem (GS) mit den festgelegten Gleichungsparametern wie folgt lautet:

$$A * x = B$$

mit

$$A = \begin{pmatrix} 1 & SOC(i_1) - p & R_2(SOC(i_1)) * I(i_1) \\ 1 & SOC(i_2) - p & R_2(SOC(i_2)) * I(i_2) \\ 1 & SOC(i_3) - p & R_2(SOC(i_3)) * I(i_3) \end{pmatrix}, B = \begin{pmatrix} U(i_1) \\ U(i_2) \\ U(i_3) \end{pmatrix}, x = \begin{pmatrix} U0_{nom} \\ dU0 \\ R_1(T) \end{pmatrix}$$

wobei $i_1$, $i_2$ und $i_3$ jeweilige Messzeitpunkte für drei erste Messdatensätze (M1) sind;
wobei $T$ die Temperatur bei den ersten Messdatensätzen (M1) ist;
wobei $R_1$ die erste Funktion ist;
wobei $R_2$ die zweite Funktion ist.

5. Verfahren nach einem der vorhergehenden Ansprüche in Kombination mit Anspruch 2, wobei die Gleichungsparameter eines der linearen Gleichungssysteme (GS) mittels der ersten Messdatensätze (M1) festgelegt werden und die ersten Messdatensätze (M1) in einem automatischen Modus des Verfahrens automatisiert aus der Vielzahl von Messdatensätzen (M1, M2, M2) basierend auf einem Toleranzwert ausgewählt werden, wobei die Temperaturen (T) von zwei Messdatensätzen als gleich eingestuft werden, wenn sie weniger als der vorbestimmte Toleranzwert voneinander abweichen, wobei die automatisierte Auswahl vorzugsweise derart ausgestaltet ist, dass die Messzeitpunkte der ersten Messdatensätze (M1) die größtmöglichen Zeitabstände zueinander haben.

6. Verfahren nach einem der vorhergehenden Ansprüche, wobei die zweiten Messdatensätze (M2) in einem automatischen Modus des Verfahrens automatisiert aus der Vielzahl von Messdatensätzen (M1, M2, M3) basierend auf einer Stromschwelle ausgewählt werden, wobei ein Stromsprung dann vorliegt, wenn der Stromfluss von einem Messdatensatz zum zeitlich nächsten Messdatensatz die vorbestimmte Stromschwelle überschreitet, wobei die automatisierte Auswahl vorzugsweise derart ausgestaltet ist, dass Paare von Messdatensätzen mit dem größtmöglichen Unterschied in dem Ladezustandsmesswert ausgewählt werden.

7. Verfahren nach einem der vorhergehenden Ansprüche in Kombination mit Anspruch 2, wobei die Gleichungsparameter eines der linearen Gleichungssysteme (GS) mittels der dritten Messdatensätze (M3) festgelegt werden und das lineare Gleichungssystem (GS) mit den festgelegten Gleichungsparametern wie folgt lautet:

$$A * x = B$$

mit

$$A = \begin{pmatrix} 1 & SOC(i_1) - p \\ 1 & SOC(i_2) - p \\ \dots & \dots \\ 1 & SOC(i_n) - p \end{pmatrix}, \qquad B = \begin{pmatrix} U(i_1) \\ U(i_2) \\ \dots \\ U(i_n) \end{pmatrix}, \qquad x = \begin{pmatrix} U0_{nom} \\ dU0 \end{pmatrix}$$

wobei $i_1$, $i_2$, ..., $i_n$ jeweilige Messzeitpunkte der dritten Messdaten sind.

8. Verfahren nach einem der vorhergehenden Ansprüche in Kombination mit Anspruch 2, wobei die Gleichungsparameter eines der linearen Gleichungssysteme (GS) mittels der dritten Messdatensätze (M3) festgelegt werden und die dritten Messdatensätze (M3) in einem automatischen Modus des Verfahrens automatisiert aus der Vielzahl von Messdatensätzen (M1, M2, M3) basierend auf einer Stromschwelle ausgewählt werden, wobei ein Stromfluss (I(t)) von null dann vorliegt, wenn der Stromfluss (I(t)) kleiner als die vorbestimmte Stromschwelle ist, wobei die automatisierte Auswahl vorzugsweise derart ausgestaltet ist, dass dritte Messdatensätzen (M3) mit größtmöglichen Unterschieden im Ladezustandsmesswert ausgewählt werden.

9. Verfahren nach einem der vorhergehenden Ansprüche in Kombination mit Anspruch 3, wobei die erste Funktion über einen oder mehrere Funktionsparameter beschrieben wird, welche unter Verwendung der ermittelten Nominalruhespannung ($U0_{nom}$) und des ermittelten Spannungsfaktors (dU0) bestimmt werden, wobei die erste Funktion vorzugsweise wie folgt lautet:

$$R_1(T) = (a_R * e^{-b_R * T} + c_R),$$

wobei $T$ die Temperatur des Energiespeichers (ES) ist;
wobei $a_R$, $b_R$ und $c_R$ die Funktionsparameter darstellen.

10. Verfahren nach Anspruch 9, wobei drei Messdatensätze zu unterschiedlichen Temperaturen (T) bei der Bestimmung des oder der Funktionsparameter einfließen, wobei vorzugsweise als die drei Messdatensätze (M1, M2, M3) aus der Vielzahl von Messdatensätzen die Messdatensätze mit dem größtmöglichen Abstand ihrer Temperaturen ausgewählt werden.

11. Vorrichtung zum rechnergestützten Ermitteln von Parametern eines elektrochemischen Energiespeichers (ES), umfassend eine Rechnereinheit, welche zur Durchführung eines Verfahrens nach einem der vorhergehenden Ansprüche eingerichtet ist.

12. Computerprogrammprodukt mit einem auf einem maschinenlesbaren Träger gespeicherten Programmcode zur Durchführung eines Verfahrens nach einem der Ansprüche 1 bis 10, wenn der Programmcode auf einem Computer ausgeführt wird.

13. Computerprogramm mit einem Programmcode zur Durchführung eines Verfahrens nach einem der Ansprüche 1 bis 10, wenn der Programmcode auf einem Computer ausgeführt wird.

**Claims**

1. Method for determining parameters of an electrochemical energy store (ES) in a computer-aided manner, wherein a multiplicity of chronologically successive measurement data records (M1, M2, M3) are processed, wherein a respective measurement data record (M1, M2, M3) comprises the following measured values for an assigned measurement time:

   a measured voltage value of a terminal voltage (U(t)) of the energy store (ES), a measured current value of a current flow (I(t)) in the form of a charging current or discharging current of the energy store (ES), and a state of charge measured value of the state of charge (SOC(t)) of the energy store (ES) ;
   wherein a predefined model (MOD) of the energy store (ES) which describes the terminal voltage (U(t)) as a function of the state of charge (SOC(t)) and the current flow (I(t)) is processed, wherein the predefined model (MOD) comprises the following indeterminate parameters:
   a nominal open-circuit voltage ($U0_{nom}$) which represents the open-circuit voltage of the energy store (ES) without a current flow (I(t)) at a predefined state of charge value (p), a voltage factor (dU0) which is part of a term of the terminal voltage (U(t)) which is dependent on the state of charge (SOC(t)), and an internal resistance (R(T,SOC)) of the energy store (ES), which is part of a term of the terminal voltage (U(t)) which is dependent on the current flow (I(t));
   wherein in the method the following steps are carried out:

      - stipulating equation parameters of at least one linear equation system (GS) which is based on the predefined model (MOD);
- determining the nominal open-circuit voltage ($U0_{nom}$) and the voltage factor (dU0) by solving the at least one linear equation system,

**characterized in that**

- the DC voltage parameters of the linear equation system, or one of the linear equation systems are stipulated by means of a plurality of second measurement data records (M2) which are pairs of measurement data records at successive measurement times with a current step in the current flows (I(t)) at the successive measurement times;
- wherein the predefined model (MOD) of the energy store (ES) is based on the following equation:

$$U(t) = U0_{nom} + dU0 * (SOC(t) - p) + R\big(T, SOC(t)\big) * I(t),$$

where $t$ is the time;
where $U(t)$ is the terminal voltage;
where $U0_{nom}$ is the nominal open-circuit voltage;
where $dU0$ is the voltage factor;
where $p$ is the predefined state of charge value;
where $SOC(t)$ is the state of charge;
where $R(T, SOC(t))$ is the internal resistance;
where $T$ is the temperature; and
where $I(t)$ is the current flow;
wherein the linear equation system, or one of the linear equation systems, with the stipulated equation parameters is as follows:

$$A * x = B$$

where

$$A = \begin{pmatrix} 1 & SOC(i_1) - p \\ 1 & SOC(i_2) - p \end{pmatrix}, \qquad B = \begin{pmatrix} U(i_1) - R(i_1) * I(i_1) \\ U(i_2) - R(i_2) * I(i_2) \end{pmatrix}, \qquad x = \begin{pmatrix} U0_{nom} \\ dU0 \end{pmatrix}$$

where $i_1$ is a measurement time from a first pair of measurement data records at successive measurement times, and $i_2$ is a measurement time from another second pair of measurement data records at successive measurement times;
where $R(i_1)$ is the internal resistance (R(T,SOC)) at the measurement time $i_1$ and is determined as a quotient of the difference of the terminal voltages (U(t)) at the measurement times of the first pair and the difference of the current flows at the measurement times of the first pair;
where $R(i_2)$ is the internal resistance (R(T,SOC)) at the measurement time $i_2$ and is determined as a quotient of the difference of the terminal voltages (U(t)) at the measurement times of the second pair and the difference of the current flows (I(t)) at the measurement times of the second pair.

2. Method according to Claim 1, wherein the stipulation of equation parameters of the at least one linear equation system (GS) additionally takes place by means of a plurality of first measurement data records (M1) in which the temperatures (T) of the energy store (ES) are essentially the same, and/or by means of a plurality of third measurement data records in which the current flows (I(t)) are essentially zero.

3. Method according to Claim 1 or 2, wherein in the predefined model (MOD) the internal resistance (R(T,SOC)) is described by a product of a first function and a second function, wherein the first function depends on the temperature (T) of the energy store (ES) and the second function depends on the state of charge (SOC(t)) of the energy store (ES), and wherein the first function is unknown and the second function is predefined.

4. Method according to Claim 2 and 3, wherein the equation parameters of one of the linear equation systems (GS) are stipulated by means of the first measurement data records (M1), and the linear equation system (GS) with the stipulated equation parameters is as follows:

$$A \; * \; x \; = \; B$$

where

$$A = \begin{pmatrix} 1 & SOC(i_1) - p & R_2(SOC(i_1)) * I(i_1) \\ 1 & SOC(i_2) - p & R_2(SOC(i_2)) * I(i_2) \\ 1 & SOC(i_3) - p & R_2(SOC(i_3)) * I(i_3) \end{pmatrix}, B = \begin{pmatrix} U(i_1) \\ U(i_2) \\ U(i_3) \end{pmatrix}, x = \begin{pmatrix} U0_{nom} \\ dU0 \\ R_1(T) \end{pmatrix}$$

where $i_1$, $i_2$ and $i_3$ are respective measurement times for three first measurement data records (M1);
where $T$ is the temperature in the first measurement data records (M1);
where $R_1$ is the first function; and
where $R_2$ is the second function.

5. Method according to one of the preceding claims in combination with Claim 2, wherein the equation parameters of one of the linear equation systems (GS) are stipulated by means of the first measurement data records (M1), and the first measurement data records (M1) are selected, in an automated manner in an automatic mode of the method, from the multiplicity of measurement data records (M1, M2, M3) on the basis of a tolerance value, wherein the temperatures (T) of two measurement data records are categorized as the same if they differ from one another by less than the predetermined tolerance value, wherein the automated selection is preferably configured in such a way that the measurement times of the first measurement data records (M1) have the largest possible time intervals from one another.

6. Method according to one of the preceding claims, wherein the second measurement data records (M2) are selected, in an automated manner in an automatic mode of the method, from the multiplicity of measurement data records (M1, M2, M3) on the basis of a current threshold, wherein a current step is present when the current flow from one measurement data record to the chronologically next measurement data record exceeds the predetermined current threshold, wherein the automated selection is preferably configured in such a way that pairs of measurement data records are selected with the greatest possible difference in the state of charge measured value.

7. Method according to one of the preceding claims in combination with Claim 2, wherein the equation parameters of one of the linear equation systems (GS) are stipulated by means of the third measurement data records (M3), and the linear equation system (GS) with the stipulated equation parameters is as follows:

$$A \; * \; x \; = \; B$$

where

$$A = \begin{pmatrix} 1 & SOC(i_1) - p \\ 1 & SOC(i_2) - p \\ \cdots & \cdots \\ 1 & SOC(i_n) - p \end{pmatrix}, \qquad B = \begin{pmatrix} U(i_1) \\ U(i_2) \\ \cdots \\ U(i_n) \end{pmatrix}, \qquad x = \begin{pmatrix} U0_{nom} \\ dU0 \end{pmatrix}$$

where $i_1$, $i_2$, ..., $i_n$ are respective measurement times of the third measurement data.

8. Method according to one of the preceding claims in combination with Claim 2, wherein the equation parameters of one of the linear equation systems (GS) are stipulated by means of the third measurement data records (M3), and the third measurement data records (M3) are selected, in an automated manner in an automatic mode of the method, from the multiplicity of measurement data records (M1, M2, M3) on the basis of a current threshold, wherein a current flow (I(t)) of zero is present when the current flow (I(t)) is less than the predetermined current threshold, wherein the automated selection is preferably configured in such a way that third measurement data records (M3) with the largest possible differences in the state of charge measured value are selected.

9. Method according to one of the preceding claims in combination with Claim 3, wherein the first function is described by means of one or more function parameters which are determined using the determined nominal open-circuit voltage (U0$_{nom}$) and the determined voltage factor (dU0), wherein the first function is preferably as follows:

$$R_1(T) = (a_R * e^{-b_R * T} + c_R),$$

where $T$ is the temperature of the energy store (ES); and
where $a_R$, $b_R$ and $c_R$ represent the function parameters.

10. Method according to Claim 9, wherein three measurement data records at different temperatures (T) are included in the determination of the one or more function parameters, wherein the measurement data records with the largest possible distance between their temperatures are preferably selected as the three measurement data records (M1, M2, M3) from the multiplicity of measurement date records.

11. Device for determining parameters of an electrochemical energy store (ES) in a computer-aided manner, comprising a computer unit which is designed to carry out a method according to one of the preceding claims.

12. Computer program product having a program code, stored on a machine-readable carrier, for carrying out a method according to one of Claims 1 to 10 when the program code is run on a computer.

13. Computer program having a program code for carrying out a method according to one of Claims 1 to 10 when the program code is run on a computer.

**Revendications**

1. Procédé destiné au calcul assisté par ordinateur de paramètres d'un accumulateur d'énergie électrochimique (ES), dans lequel une pluralité de jeux de données de mesure successifs (M1, M2, M3) sont traités, dans lequel un jeu de données de mesure (M1, M2, M3) respectif comprend les valeurs de mesure suivantes pour un moment de mesure associé :

une valeur de mesure de tension d'une tension terminale (U(t)) de l'accumulateur d'énergie (ES), une valeur de mesure de courant d'un flux de courant (I(t)) sous la forme d'un courant de charge ou de décharge de l'accumulateur d'énergie (ES) et une valeur de mesure d'état de décharge de l'état de charge (SOC(t)) de l'accumulateur d'énergie (ES) ;
dans lequel un modèle prédéfini (MOD) de l'accumulateur d'énergie (ES) est traité, lequel décrit la tension terminale (U(t)) en fonction de l'état de charge (SOC(t)) et du flux de courant (I(t)), dans lequel le modèle prédéfini (MOD) comprend les paramètres indéterminés suivants :

une tension nominale de repos (U0$_{nom}$) qui représente la tension de repos de l'accumulateur d'énergie (ES) sans flux de courant (I(t)) pour une valeur d'état de charge prédéfinie (p), un coefficient de tension (dU0) qui fait partie d'un terme de la tension terminale (U(t)) dépendant de l'état de charge (SOC(t)) et une résistance interne (R(T, SOC)) de l'accumulateur d'énergie (ES) qui fait partie d'un terme de la tension terminale (U(t)) dépendant du flux de courant (I(t)) ;
dans lequel les étapes suivantes sont réalisées dans le procédé :

- spécification de paramètres d'équation d'au moins un système d'équations linéaires (GS) qui se base sur le modèle prédéfini (MOD) ;
- calcul de la tension nominale de repos (U0$_{nom}$) et du coefficient de tension (dU0) par le biais de la résolution d'au moins un système d'équations linéaires, **caractérisé en ce que**
- les paramètres de tension continue du ou d'un des systèmes d'équations linéaires sont spécifiés au moyen de deuxièmes jeux de données (M2) qui sont des paires de jeux de données de mesure à des moments de mesure successifs avec une saute de courant dans les flux de courant (I(t)) à des moments de mesure successifs ;

- dans lequel le modèle prédéfini (MOD) de l'accumulateur d'énergie (ES) se base sur l'équation suivante :

$$U(t) = U0_{nom} + dU0 * (SOC(t) - p) + R\big(T, SOC(t)\big) * I(t),$$

- dans lequel $t$ est le temps ;
- dans lequel $U(t)$ est la tension terminale ;
- dans lequel $U0_{nom}$ est la tension nominale de repos ;
- dans lequel $dU0$ est le coefficient de tension ;
- dans lequel $p$ est la valeur d'état de charge prédéfinie ;
- dans lequel $SOC(t)$ est l'état de charge ;
- dans lequel $R(T, SOC(t))$ est la résistance interne ;
- dans lequel $T$ est la température ;
- dans lequel $I(t)$ est le flux de courant ;
- dans lequel le ou un des systèmes d'équations linéaires avec les paramètres d'équation spécifiés sont les suivants :

$$A * x = B$$

avec

$$A = \begin{pmatrix} 1 & SOC(i_1) - p \\ 1 & SOC(i_2) - p \end{pmatrix}, \qquad B = \begin{pmatrix} U(i_1) - R(i_1) * I(i_1) \\ U(i_2) - R(i_2) * I(i_2) \end{pmatrix}, \qquad x = \begin{pmatrix} U0_{nom} \\ dU0 \end{pmatrix}$$

dans lequel $i_1$ est un moment de mesure issu d'une première paire de jeux de données de mesure à des moments de mesure successifs et $i_2$ est un moment de mesure issu d'une autre deuxième paire de jeux de données de mesure à des moments de mesure successifs ;

dans lequel $R(i_1)$ est la résistance interne (R(T, SOC)) au moment de mesure $i_1$ et est calculé en tant que quotient à partir de la différence des tensions terminales (U(t)) aux moments de mesure de la première paire et de la différence des flux de courant aux moments de mesure de la première paire ;

dans lequel $R(i_2)$ est la résistance interne (R(T, SOC)) au moment de mesure $i_2$ et est calculé en tant que quotient à partir de la différence des tensions terminales (U(t)) aux moments de mesure de la deuxième paire et de la différence des flux de courant (I(t)) aux moments de mesure de la deuxième paire.

2. Procédé selon la revendication 1, dans lequel la spécification de paramètres d'équation de l'au moins un système d'équations linéaires (GS) intervient en outre au moyen de plusieurs premiers jeux de données de mesure (M1), dans lesquels les températures (T) de l'accumulateur d'énergie (ES) sont sensiblement du même ordre de grandeur, et/ou au moyen de plusieurs troisièmes jeux de données de mesure, dans lesquels les flux de courant (I(t)) sont sensiblement égaux à zéro.

3. Procédé selon la revendication 1 ou 2, dans lequel dans le modèle prédéfini (MOD) la résistance interne (R(T, SOC)) est décrite par le biais d'un produit issu d'une première fonction et d'une deuxième fonction, dans lequel la première fonction dépend de la température (T) de l'accumulateur d'énergie (ES) et la deuxième fonction dépend de l'état de charge (SOC(t)) de l'accumulateur d'énergie (ES) et dans lequel la première fonction est inconnue et la deuxième fonction est prédéfinie.

4. Procédé selon les revendications 2 et 3, dans lequel les paramètres d'équation d'un des systèmes d'équations linéaires (GS) sont spécifiés au moyen des premiers jeux de données de mesure (M1) et le système d'équations linéaires (GS) avec les paramètres d'équation spécifiés est le suivant :

$$A * x = B$$

avec

$$A = \begin{pmatrix} 1 & SOC(i_1) - p & R_2(SOC(i_1)) * I(i_1) \\ 1 & SOC(i_2) - p & R_2(SOC(i_2)) * I(i_2) \\ 1 & SOC(i_3) - p & R_2(SOC(i_3)) * I(i_3) \end{pmatrix}, B = \begin{pmatrix} U(i_1) \\ U(i_2) \\ U(i_3) \end{pmatrix}, x = \begin{pmatrix} U0_{nom} \\ dU0 \\ R_1(T) \end{pmatrix}$$

dans lequel $i_1$, $i_2$ et $i_3$ sont des moments de mesure respectifs pour trois premiers jeux de données de mesure (M1) ;

dans lequel $T$ est la température dans les premiers jeux de données de mesure (M1) ;

dans lequel $R_1$ est la première fonction ;

dans lequel $R_2$ est la deuxième fonction.

5. Procédé selon l'une des revendications précédentes en combinaison avec la revendication 2, dans lequel les paramètres d'équation d'un des systèmes d'équations linéaires (GS) sont spécifiés au moyen des premiers jeux de données de mesure (M1) et les premiers jeux de données de mesure (M1) sont sélectionnés dans un mode automatique du procédé de matière automatisée à partir de la pluralité de jeux de données de mesure (M1, M2, M3) en se basant sur une valeur de tolérance, dans lequel les températures (T) de deux jeux de données de mesure sont classées comme étant identiques lorsqu'elles présentent entre elles un écart inférieur à la valeur de tolérance prédéterminée, dans lequel la sélection automatisée est conçue de préférence de telle sorte que les moments de mesure des premiers jeux de données de mesure (M1) ont entre eux les écarts de temps les plus élevés possibles.

6. Procédé selon l'une des revendications précédentes, dans lequel les deuxièmes jeux de données de mesure (M2) sont sélectionnés dans un mode automatique du procédé de manière automatisée à partir de la pluralité de jeux de données de mesure (M1, M2, M3) en se basant sur un seuil de courant, dans lequel une saute de courant est présente dès lors que le flux de courant dépasse le seuil de courant prédéterminé d'un jeu de données de mesure au jeu de données de mesure suivant dans le temps, dans lequel la sélection automatisée est conçue de préférence de telle sorte que des paires de jeux de données de mesure sont sélectionnées avec la différence la plus élevée possible dans la valeur de mesure d'état de charge.

7. Procédé selon l'une des revendications précédentes en combinaison avec la revendication 2, dans lequel les paramètres d'équation d'un des systèmes d'équations linéaires (GS) sont spécifiés au moyen des troisièmes jeux de données de mesure (M3) et le système d'équations linéaires (GS) avec les paramètres d'équation spécifiés est le suivant :

$$A * x = B$$

avec

$$A = \begin{pmatrix} 1 & SOC(i_1) - p \\ 1 & SOC(i_2) - p \\ \cdots & \cdots \\ 1 & SOC(i_n) - p \end{pmatrix}, \qquad B = \begin{pmatrix} U(i_1) \\ U(i_2) \\ \cdots \\ U(i_n) \end{pmatrix}, \qquad x = \begin{pmatrix} U0_{nom} \\ dU0 \end{pmatrix}$$

dans lequel $i_1$, $i_2$, ..., $i_n$ sont des moments de mesure respectifs des troisièmes données de mesure.

8. Procédé selon l'une des revendications précédentes en combinaison avec la revendication 2, dans lequel les paramètres d'équation d'un des systèmes d'équations linéaires (GS) sont spécifiés au moyen des troisièmes jeux de données de mesure (M3) et les troisièmes jeux de données de mesure (M3) sont sélectionnés dans un mode automatique du procédé de manière automatisée à partir de la pluralité de données de mesure (M1, M2, M3) en se basant sur un seuil de tension, dans lequel un flux de courant (I(t)) égal à zéro est présent dès lors que le flux de courant (I(t)) est plus bas que le seuil de courant prédéterminé, dans lequel la sélection automatisée est de préférence conçue de telle sorte que des troisièmes jeux de données de mesure (M3) sont sélectionnés avec des différences les plus élevées possibles dans la valeur de mesure d'état de charge.

9. Procédé selon l'une des revendications précédentes en combinaison avec la revendication 3, dans lequel la première fonction est décrite via un ou plusieurs paramètres de fonction, lesquels sont déterminés en utilisant la tension nominale de repos ($U0_{nom}$) déterminée et le coefficient de tension (dU0) déterminé, dans lequel la première fonction est de préférence la suivante :

$$R_1(T) = (a_R * e^{-b_R*T} + c_R) \,,$$

dans lequel $T$ est la température de l'accumulateur d'énergie (ES) ;
dans lequel $a_R$, $b_R$ et $c_R$ représentent les paramètres de fonction.

10. Procédé selon la revendication 9, dans lequel trois jeux de données de mesure passent à des températures (T) différentes lors de la détermination du ou des paramètres de fonction, dans lequel les jeux de données de mesure sont sélectionnés avec le plus grand écart possible de leurs températures de préférence en tant que trois jeux de données de mesure (M1, M2, M3) à partir de la pluralité de jeux de données de mesure.

11. Dispositif destiné au calcul assisté par ordinateur de paramètres d'un accumulateur d'énergie électrochimique (ES), comprenant une unité informatique qui est adaptée pour la réalisation d'un procédé selon l'une des revendications précédentes.

12. Produit de programme informatique avec un code de programme mis en mémoire sur un support lisible par une machine destiné à la réalisation d'un procédé selon l'une des revendications 1 à 10 lorsque le code de programme est exécuté sur un ordinateur.

13. Programme informatique avec un code de programme destiné à la réalisation d'un procédé selon l'une des revendications 1 à 10 lorsque le code de programme est exécuté sur un ordinateur.

# FIG 1

# FIG 2

$$\text{M1, M2, M3}$$
$$\text{MOD: } U(t) = U0_{nom} + dU0 * (SOC(t)-p) + R(T, SOC(t)) * I(t)$$

S1

GS — S2

$U0_{nom}, dU0$ — S3

## FIG 3

R$_2$ (SOC)

SOC [%]

## FIG 4

X: 155.8
Y: 18

X: 106.9
Y: -18

I [A]

t [min]

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- An overview of generic battery models. **ALA AL-HAJ HUSSEIN et al.** Power and Energy Society General Meeting, 2011 IEEE. IEEE, 24. Juli 2011, 1-6